Europäisches Patentamt

European Patent Office

Office européen des brevets

Publication number: **0 296 697**
**A2**

## EUROPEAN PATENT APPLICATION

(21) Application number: 88302474.7

(22) Date of filing: 22.03.88

(51) Int. Cl.⁴: **G06F 15/60**

(30) Priority: 24.06.87 US 65929

(43) Date of publication of application:
28.12.88 Bulletin 88/52

(84) Designated Contracting States:
**DE FR GB**

(71) Applicant: **ETA SYSTEMS, INC.**
**1450 Energy Park Drive**
**St. Paul, MN 55108(US)**

(72) Inventor: **Doyle, John Joseph**
**7391 Tempo Terrace**
**Fridley Minnesota 55432(US)**

(74) Representative: **Caro, William Egerton et al**
**J. MILLER & CO. Lincoln House 296-302 High**
**Holborn**
**London WC1V 7JH(GB)**

(54) **A method of operating a digital computer to set routing paths.**

(57) A method of operating a digital computer to set routing paths along an x-y grid (10) of possible paths, between a plurality of terminals (60, 62, 64, 66, 68) on an integrated circuit, includes:

a) determining an average position on the grid of the terminals (60,62, 64, 66, 68) to be interconnected;

b) identifying a first terminal (64) closest to the average position along x and/or y paths of the grid;

c) identifying a second terminal (62) closest to the first terminal (64) along x and/or y paths of the grid;

d) establishing a first path (70) along x and/or y paths of the grid between the first and second terminals (64, 62), wherein the first path (70) is rectangular and has four edges (72A-72D) and four vertices (74A-74D) including the first and second terminals (64, 62) when the first and second terminals are on different x and different y paths, and wherein the first path (70) is a line and has one edge and two vertices including the first and second terminals when the first and second terminals are on the same x or same y path;

e) setting the edge of the first path (70) as a routing path if the first path is a line;

f) identifying a closest remaining terminal (66) which is closest along x and/or y paths of the grid, to an edge (72B) or vertex of an established path (70) having no set edges. or to a set edge or its vertices of an established path which has a set edge, whichever is closest;

g) establishing a shortest path (76) along x and/or y paths of the grid between the closest terminal (66) and the edge or vertex of the established path to which it was closest, wherein the shortest path is rectangular and has four edges (78) and four vertices (80A, 80B) including the closest terminal (66) and a vertex common with a vertex of the established path (70) when the shortest path traverses both x and y paths of the grid, and wherein the shortest path is in line and has an edge and two vertices including the closest terminal when the shortest path traverses only x or only y paths of the grid;

h) setting as a routing path edges (72A, 72B) of the established path (70) which couple its vertices (74A, 74C) which include terminals (62, 64) and which have a vertex in common with the shortest path, if the established path has no set edges and the common vertex does not include a terminal;

i) setting as a routing path the edge of the shortest path (76) which couples the closest terminal to the edge (72B) or vertex of the established path (70) if the shortest path is a line and has a vertex common with a vertex of the established path, or is a line and has a vertex at a set edge of the established path;

j) repeating steps f) to i) for remaining termi-
nals to be interconnected.

Fig. 6A

# A METHOD OF OPERATING A DIGITAL COMPUTER TO SET ROUTING PATHS

This invention relates to methods of operating digital computers to set routing paths, for example between circuit elements or macros on an integrated circuit. In one embodiment, the present invention is to a method of globally assigning interconnect paths to vertical and horizontal routing channels of a gate array.

Gate arrays are commonly used integrated circuits on which a large number of transistors are fabricated in a geometric pattern of vertical columns and horizontal rows. During subsequent manufacturing steps, the gate array is personalized by interconnecting individual transistors to form basic circuit elements or macros, and interconnecting the macros to form a functional integrated circuit with larger scale logic systems. This customization of the gate array is done through the application of several metal interconnect layers over the transistors. Each metal layer is typically partitioned into a plurality of vertical routing channels and horizontal routing channels. Each vertical routing channel includes a plurality of possible routing paths or tracks. Similarly, each vertical routing channel includes a plurality of possible vertical routing tracks.

Routing tracks for macro intraconnect metal, the metal used to connect individual transistors and form the macros, is predetermined. Once the location of a macro is established, the precise horizontal and vertical routing tracks to which the macro intraconnect metal will be applied can be determined.

After all the macro intraconnects on a gate array have been established, it is necessary to route or assign the macro interconnect metal, the metal used to interconnect the macros, to horizontal and vertical routing tracks. Various procedures for routing macro interconnect metal are known. Utilizing one known procedure a net list, a group of macro terminals which must be interconnected, is first identified. Interconnects between terminals of the net are then globally routed to vertical and horizontal routing channels. One global router algorithm permits interconnects to be assigned to any routing channels within a rectangular area encompassing all terminals of the net. A maze router is then used to assign horizontal segments of the globally routed interconnects to specific tracks of the horizontal channels. This procedure is repeated for all nets on the integrated circuit. Finally, a channel router is used to assign vertical segments of the globally routed interconnects to specific tracks of the vertical channels.

To increase the performance of integrated circuit gate arrays, designers are increasing the density of transistors fabricated thereon. The transistors are therefore being spaced ever closer to one another, decreasing the amount of space available for interconnects. The overall size of gate arrays is also increasing, permitting larger numbers of macros to be fabricated on the gate array and thereby increase its capabilities. The more macros formed on the gate array, however, the greater the demands that are placed upon the router. Problems resulting from the increased transistor density are therefore compounded. In view of the fact that the spacing between transistors is being decreased while the amount of space required for routing tracks is finite, the number of available tracks for routing intraconnect and interconnect metal with respect to the number of transistors in a given area on the integrated circuit is decreasing.

It is evident that with the increase in size and density of gate arrays there is a continuing need for improved methods for routing interconnect metal. The routing procedure must efficiently utilize available routing paths to reduce wiring congestion. It is important for the router to keep the length of macro interconnects to a minimum to reduce skews or timing errors due to signal propagation delays. Reliability, the ability to route all required interconnects, and speed. are also required of the router.

According to one aspect of the present invention there is provided a method of operating a digital computer to set routing paths along an x-y grid of possible paths, between a plurality of terminals on an integrated circuit, characterised by including:

a) determining an average position on the grid of the terminals to be interconnected;

b) identifying a first terminal closest to the average position along x and/or y paths of the grid;

c) identifying a second terminal closest to the first terminal along x and/or y paths of the grid;

d) establishing a first ath along x and/or y paths of the grid between the first and second terminals wherein the first path is rectangular and has four edges and four vertices including the first and second terminals when the first and second terminals are on different x and y paths, and wherein the first path is a line and has one edge and two vertices including the first and second terminals when the first and second terminals are on the same x or y path;

e) setting the edge of the first path as a routing path if the first path is a line;

f) identifying a closest remaining terminal which is closest along x and/or y paths of the grid, to an edge or vertex of an established path having no set edges, or to a set edge or its vertices of an established path which has a set edge, whichever is closest;

g) establishing a shortest path along x and/or y paths of the grid between the closest terminal and the edge or vertex of the established path to which it was closest, wherein the shortest path is rectangular and has four edges and four vertices including the closest terminal and a vertex common with a vertex of the established path when the shortest path traverses both x and y paths of the grid, and wherein the shortest path is in line and has an edge and two vertices including the closest terminal when the shortest path traverses only x or only y paths of the grid;

h) setting as a routing path edges of the established path which couple its vertices which include terminals and which have a vertex in common with the shortest path, if the established path has no set edges and the common vertex does not include a terminal;

i) setting as a routing path the edge of the shortest path which couples the closest terminal to the edge or vertex of the established path if the shortest path is a line and has a vertex common with a vertex of the established path, or is a line and has a vertex at a set edge of the established path; and

j) repeating steps f) to i) for remaining terminals to be interconnected.

Preferably the method includes, between steps i) and j):

k) re-establishing the established path to which the closest terminal was closest if the established path is a rectangle with no set edges and the shortest path is a line which does not have a vertex common with a vertex of the established path, wherein the re-established established path is rectangular and has four edges and four vertices including two vertices of the established path and a vertex common with the vertex of the shortest path which intersected the established path;

l) re-establishing the shortest path if the shortest path is a line and does not have a vertex common with a vertex of the established path to which the closest terminal was closest (prior to being re-established if it was re-established), wherein the re-established shortest path is a rectangle and has four edges and four vertices including a vertex including the closest terminal, a vertex at the intersection of the shortest path and the established path or the re-established established path, and a vertex common with a vertex of the established path (prior to being re-established if it was re-established) which includes a terminal; and

m) setting as a routing path edges of the re-established shortest path which couple its vertices which include terminals and which have a vertex common with a vertex of the established path or the re-established established path.

According to another aspect of the present invention there is provided a method of operating a digital computer to set routing paths, along an x-y grid of possible paths, between a plurality of terminals on an integrated circuit, characterised by including:

a) determining an average position on the grid of the terminals to be interconnected;

b) identifying a first terminal closest to the average position along x and/or y paths of the grid;

c) identifying a second terminal closest to the first terminal along x and/or y paths of the grid;

d) establishing a first path along x and/or y paths of the grid between the first and second terminals wherein the first path is rectangular and has four edges and four vertices including the first and second terminals when the first and second terminals are on different x and different y paths, and wherein the first path is a line and has one edge and two vertices including the first and second terminals when the first and second terminals are on the same x or same y path;

e) setting the edge of the first path as a routing path if the first path is a line;

f) identifying a closest remaining terminal which is closest, along x and/or y paths of the grid, to an edge or vertex of an established path having no set edges, or to a set edge or its vertices of an established path which has a set edge, whichever is closest;

g) establishing a shortest path along x and/or y paths between the closest terminal and the edge or vertex of the established path to which it was closest, wherein the shortest path is rectangular and has four edges and four vertices including the closest terminal and a vertex common with a vertex of the established path when the shortest path traverses both x and y paths, and wherein the shortest path is a line and has an edge and two vertices including the closest terminal when the shortest path traverses only x or only y paths;

h) setting as a routing path edges of the established path which couple its vertices which are also terminals and which have a vertex common with a vertex of the shortest path, if the established path has no set edges and the common vertex does not include a terminal;

i) setting as a routing path the edge of the shortest path which couples the closest terminal to the edge or vertex of the established path if the shortest path is a line and has a vertex common with a vertex of the established path, or is a line and has a vertex at a set edge of the established path;

j) re-establishing the established path to which the closest terminal was closest if the established path is a rectangle with no set edges and the shortest path is a line which does not have a vertex common with a vertex of the established path, wherein the re-established established path is rectangular and has four edges and four vertices including two vertices of the established path and a vertex common with the vertex of the shortest path which intersected the established path;

k) re-establishing the shortest path if the shortest path is a line and does not have a vertex common with a vertex of the established path to which the closest terminal was closest (prior to being re-established if it was re-established), wherein the re-established shortest path is a rectangle and has four edges and four vertices including a vertex at the location of the closest terminal, a vertex at the location at which the shortest path intersected the established path or the re-established established path, and a vertex common with a vertex of the established path (prior to being re-established if it was re-established), which includes a terminal;

l) setting as a routing path edges of the re-established shortest path which couple its vertices which include terminals and which have a vertex common with a vertex of the established path or the re-established established path; and

m) repeating steps f) to l) for remaining terminals to be interconnected.

Preferably the method includes setting as a routing path any of the possible paths within and including edges of the established paths which have no set edges and which couple the terminals of the established paths to a set edge or its vertices of an established path having a set edge.

The invention is illustrated, merely by way of example, in the accompanying drawings, in which:-

Figure 1 is a graphic representation of a portion of a gate array having transistors fabricated thereon;

Figure 2 is a block diagram representation of a computer to which can be applied a method according to the present invention of operating a digital computer to set routing paths;

Figure 3 is a flow chart describing a routing procedure which can include a global routing method according to the present invention;

Figure 4 is a graphic representation of a gate array such as that shown in Figure 1 on which circuit elements, represented in schematic form, have been fabricated, and illustrating possible routing tracks;

Figure 5 is a written description of a method according to the present invention of operating a digital computer to set routing paths; and

Figures 6A-6E graphically illustrate the routing procedure of a method according to the present invention as applied to the circuit layout of the gate array shown in Figure 4.

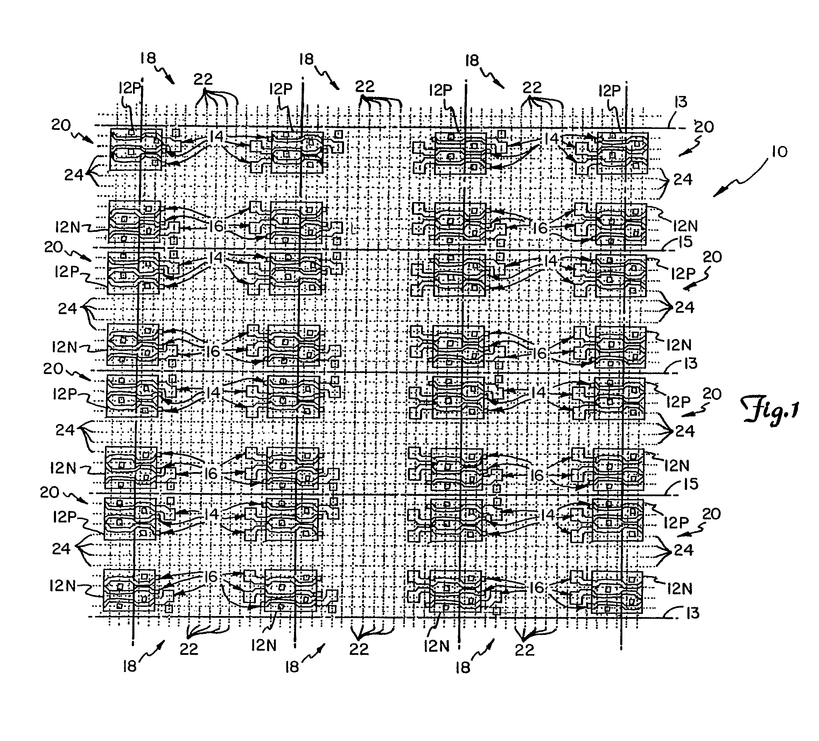

The present invention relates to a method of operating a programmable digital computer as an automatic integrated circuit layout router to lay out routing or interconnect paths on an integrated circuit such as a gate array 10 which is illustrated in Figure 1. Gate arrays such as that illustrated in Figure 1 are well known. The gate array 10 may be fabricated using CMOS technology and includes a plurality of positive supply rails 13 alternately positioned between and parallel to negative supply rails 15. A plurality of P-channel cells 12P and N-channel cells 12N, which are arranged in vertical columns and horizontal rows, are also fabricated on the gate array 10. In the embodiment shown, each cell 12P includes three P-channel transistors 14, while each cell 12N includes three N-channel transistors 16. Only a portion of the gate array 10 is shown in Figure 1. In one embodiment, the gate array 10 is ninety-five cells 12P and 12N wide (horizontally) and one hundred and twenty-seven cells high (vertically).

The gate array 10 is personalized, or has its P-channel transistors 14 and N-channel transistors 16 interconnected to form circuit elements or macros and the macros interconnected to form larger scale logic systems, by two metal interconnect layers (not shown). Each metal layer is partitioned into a plurality of vertical routing channels 18 and horizontal routing channels 20. For purposes of convention, sides of vertical routing channels 18 are shown centered over cells 12P, 12N, while sides of horizontal routing channels 20 are centered on supply rails 13, 15.

In the embodiment shown, each vertical routing channel 18 includes sixteen possible vertical routing paths or tracks 22 at which interconnect metal can be deposited on one of the two metal layers. Horizontal routing channels 20 each include eleven possible horizontal routing paths or tracks 24 at which interconnect metal can be deposited. Vertical routing tracks 22 and horizontal routing tracks 24 thereby form an orthogonal x-y grid of possible routing paths over the gate array 10. It is to be understood that although the routing paths 22, 24 are illustrated by broken lines in Figure 1, they represent no physical structure of the gate array 10 and are simply possible locations for interconnect metal. As a general rule, metal interconnects along the vertical tracks 22 are made on the first metal layer, while interconnects along the horizontal tracks 24 are made on the second metal layer. The first and second metal layers are separated by an insulating layer in a well known manner. Vias, the interconnections between metal layers, can be made at designated intersections of the vertical routing tracks 22 and the horizontal routing tracks 24. In one embodiment only diagonally adjacent vias are permitted. Orthogonally adjacent vias are not allowed at any intersection.

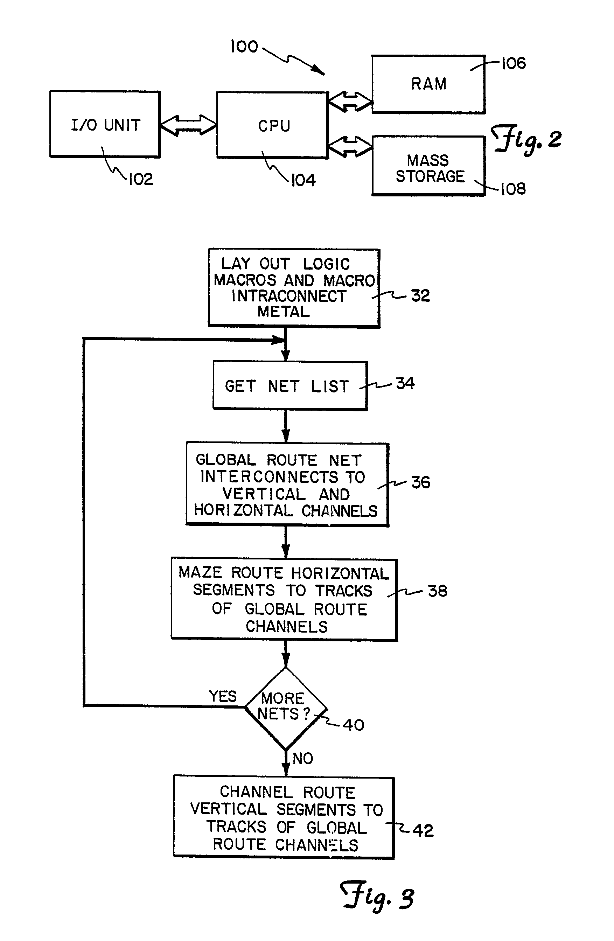

The routing procedure of the method according to the present invention is preferably implemented by a digital computer 100 such as that illustrated generally in Figure 2. The computer 100 includes an input/output (I/O) unit 102, a central processing unit (CPU) 104, a random access memory (RAM) 106 and a mass storage memory 108 such as magnetic tape. Macro intraconnects, the relative paths by which metal is applied to the gate array 10 to fabricate particular macros from the transistors 14, 16, and contact cuts, the interconnections between the first metal layer and the transistors 14, 16 of the cells 12P, 12N, respectively, are predetermined, and data characteristic thereof will be stored in the RAM 106 or the mass storage memory 108.

Data required to personalize a particular gate array 10, including that characteristic of macros to be fabricated on the gate array, their locations and the interconnections required between macros, is input to the computer 100 through the I/O unit 102. This data can be stored within the RAM 106. Instruction data characterizing a router algorithm can be stored in the mass storage memory 108. The input data is processed by the CPU 104 in accordance with the router algorithm to generate data representative of the particular vertical tracks 22 and the horizontal tracks 24 to which interconnect metal will be applied to interconnect terminals of the macros. This data, along with data from intermediate processing steps, is stored in the RAM 106. Data characterizing all interconnects on the gate array 10 is then output from the computer 100 to the I/O unit 102 (e.g. on magnetic tape), and used to personalize the gate array during fabrication

The router algorithm, or the procedure utilized by the computer 100 to determine routing paths on the gate array 10, is described generally with reference to Figure 3. A first step 32 is to lay out or position the logic macros and the macro intraconnect metal on the gate array 10. This step is performed by storing data characterizing the particular transistors 14, 16 from which the macro will be constructed, and the particular tracks 22, 24 to which intraconnect metal will be applied to form the logic macros. As described above, relative intraconnections between transistors 14, 16 for each macro within a macro or cell library are predetermined and stored in memory. Once the particular transistors 14, 16 which will be used to fabricate the macro are identified the particular tracks 22, 24 to which metal must be applied can be quickly determined, and data representative thereof stored. Following this procedure, data characterizing macros such as gates, shift registers, multiplexers, etc., which depending upon their complexity can use from two to over one hundred cells 12P, 12N, can be stored in the RAM 106. Layout procedures such as those described above with reference to step 32 are well known.

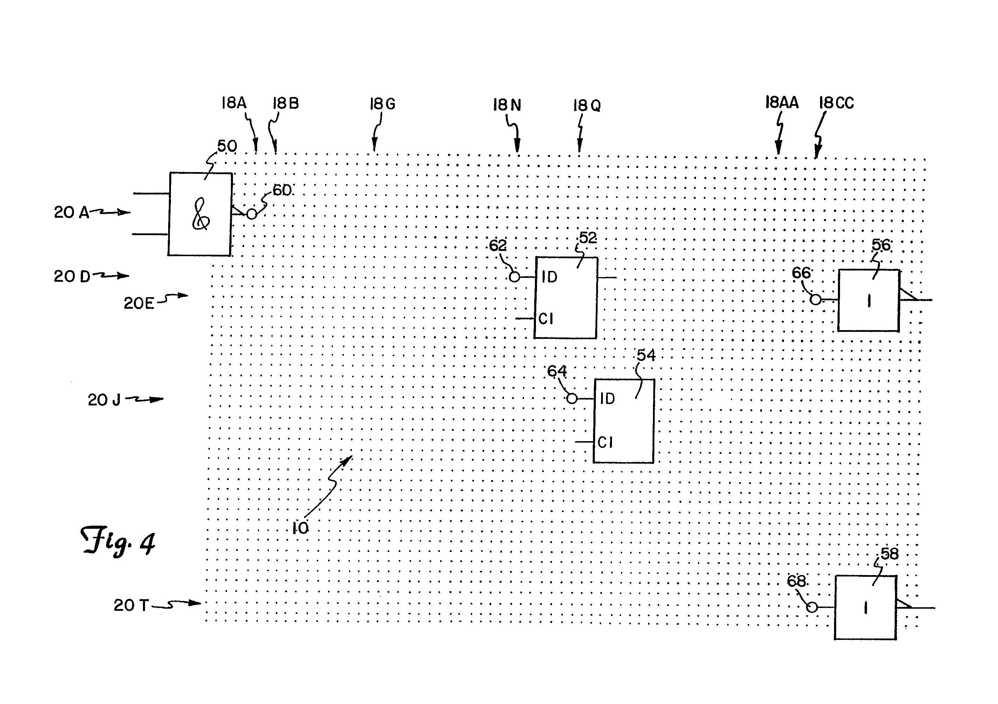

Figure 4 is a graphical representation of a plurality of logic macros including an AND gate 50, D-flip-flops 52, 54, and inverters 56, 58 which are positioned at specific locations on the gate array 10. Although the AND gate 50, the flip-flops 52, 54 and the inverters 56, 58 are illustrated schematically for purposes of example, it is to be understood that these logic macros are actually formed by the transistors 14, 16 which are interconnected by macro intraconnect metal. Vertical routing channels 18A-18CC and horizontal routing channels 20A-20T are illustrated in Figure 4. As shown, the AND gate 50 has an output terminal 60 at the intersection of channels 18A, 20A. The flip-flops 62, 64 have D-input terminals 62, 64 located at intersections of channels 18N, 20D, and 18Q, 20J, respectively. The inverters 56, 58 have input terminals 66, 68 located at intersections of channels 18CC, 20E, and 18CC, 20T, respectively.

Referring back to Figure 3, after macro intraconnect metal has been layed out and data representative thereof stored in memory, the macros themselves must be interconnected. This procedure is initiated by identifying a net list as indicated at step 34. The net list is a group of macro terminals which must be interconnected. Using the macros of Figure 4 as an example, the output terminal 60 of the AND gate 50 must be connected to the D-input terminals 62, 64 of the flip-flops 52, 54. respectively, and to input terminals 66, 68 of the inverters 56, 58, respectively. This particular net list will include data representative of terminals 60, 62, 64, 66, 68, and their locations on the gate array 10. This data will be stored in the RAM 106 (Figure 2). Procedures for obtaining and storing data representative of net lists and represented by step 34 are well known.

Once a net list is gathered, a global routing algorithm is followed by the computer 100 to determine which segments or portions of which vertical channels 18A-18CC and which horizontal channels 20A-20T the interconnect metal will follow. Global routing is indicated by step 36 in Figure 3. Data representative of a set of instructions characterizing the global routing algorithm will be stored in the mass storage memory 108 (Figure 2). A detailed description of a global router algorithm is given subsequently.

After global routing of a given net has been completed, portions or segments of the interconnect paths within the horizontal channels 20A-20T are assigned to specific horizontal tracks 24 within the horizontal channels. In one embodiment, a maze router algorithm is used for this purpose. This step is illustrated at 38 in Figure 3. Instructions characteristic of the maze router algorithm can be stored in the mass storage memory 108. Maze router algorithms of this type are well known.

As indicated at step 40 in Figure 3, the next step performed by the computer 100 is to determine whether or not there are any more nets on the gate array 10 which must still be global routed and maze routed. If there are additional nets, the computer 100 first gathers the net list as illustrated at step 34, performs a global route of the net interconnects to the vertical channels 18A-18CC and the horizontal channels 20A-20T as shown at step 36, and maze routes the horizontal segments to the horizontal tracks 24 as illustrated by step 38. These steps can be performed in a manner identical to those described above.

Finally, after all nets on the gate array 10 have been global routed and maze routed in the manner described above, a channel router is implemented to assign all vertical segments of each net to specific vertical tracks 22 of the vertical channels 18S-18CC. This step is illustrated at 42 in Figure 3. In one embodiment, a dogleg channel router is used for this purpose. Channel routers of this type are well known.

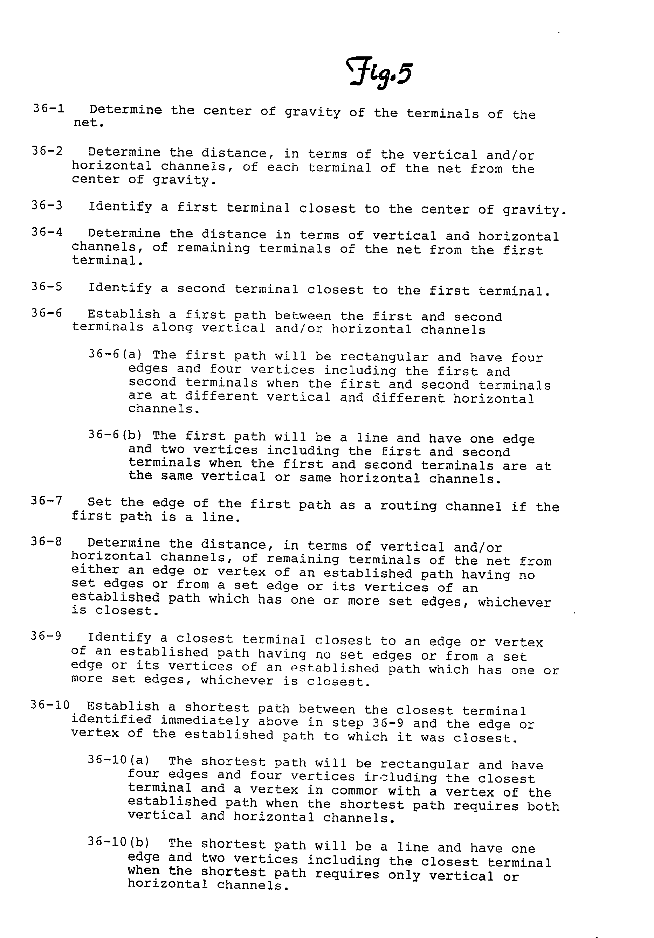

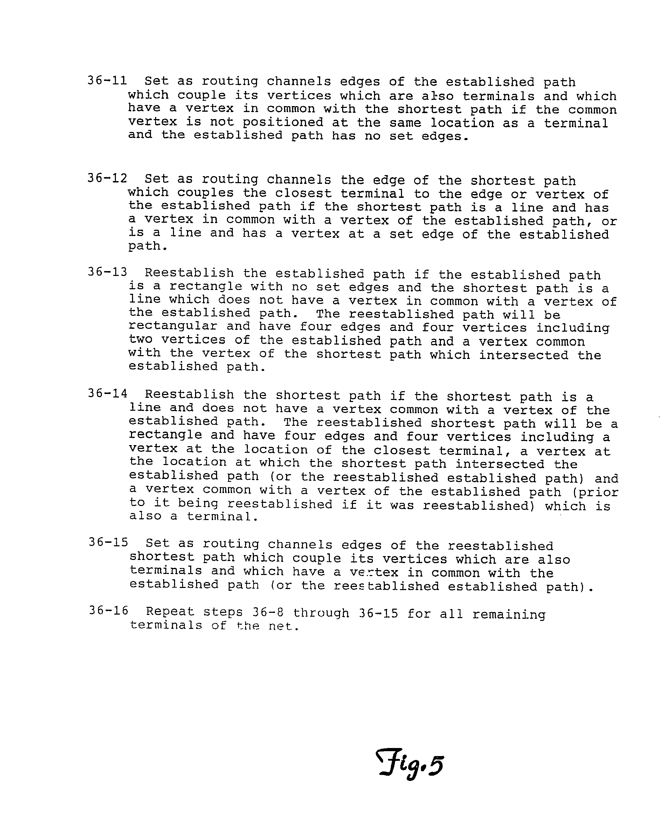

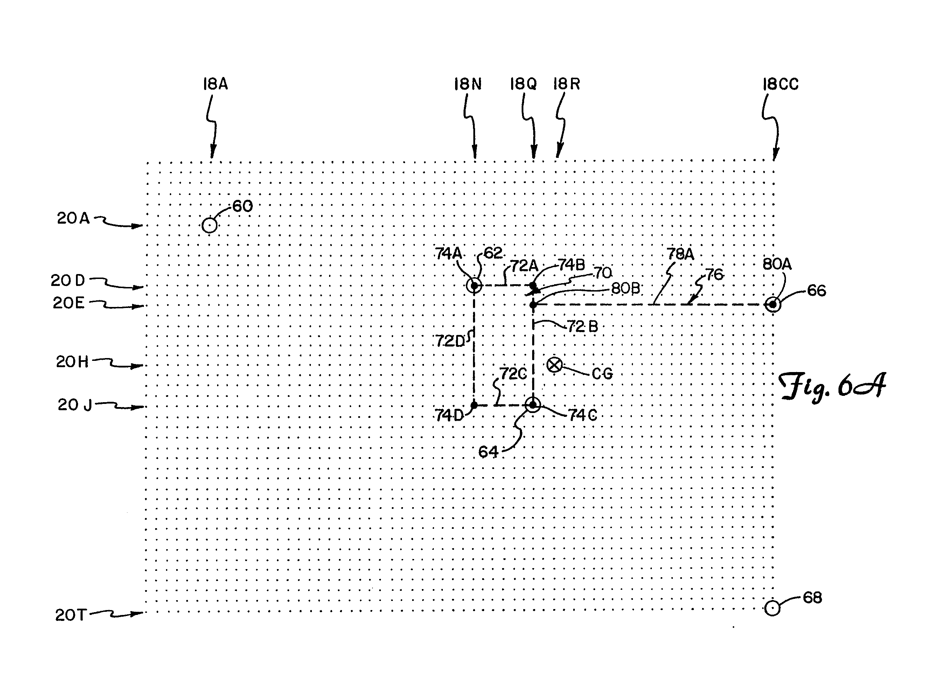

A global router algorithm which can be utilized at the step 36 in the overall routing procedure described above, is described with reference to Figures 5 and 6A-6E. Figure 5 is a flow chart which describes in detail the steps of the global router algorithm which was described generally at step 36. Figures 6A-6E are graphical representations of the application of the global router algorithm by the computer 100 to interconnect the net formed by the terminals 60, 62, 64, 66, 68 of macros 50, 52, 54, 56, 58, respectively, shown in Figure 4.

A first step 36-1 implemented by the computer 100 in accordance with global router algorithm 36 is to determine an average position of all terminals of the net, e.g., terminals 60, 62, 64, 66, 68. In the embodiment described, step 36-1 is performed by computing a centre of gravity in terms of the average x or horizontal channel 18A-18CC position, and the average y or vertical channel 20A-20T position. In the example illustrated in Figure 6A, the terminal 60 is at an x-y channel position of (18A,20A), while the terminals 62, 64, 66, 68 have channel positions of (18N,20D), (18Q,20J), (18CC,20E), and (18CC,20T), respectively. A centre of gravity (CG) of terminals 60, 62, 64, 66, 68 is found by a simple average to be located at a channel position of (18R,20H).

In accordance with a second step 36-2, the computer 100 will next compute the distance, in terms of the number of horizontal channels 18A-18CC and vertical channels 20A-20T, by which each terminal 60, 62, 64, 66, 68 within the net is separated from the centre of gravity CG. Utilizing this information, a first terminal which is closest to the centre of gravity CG can be identified as indicated by step 36-3. In the example shown in Figure 6A, the terminal 64 is closest to the centre of gravity CG, being one vertical channel 18A-18CC and two horizontal channels 20A-20T therefrom. If more than one terminal 60, 62, 64, 66, 68 was the same closest distance from the centre of gravity CG, any can be used as the first terminal.

Following the router algorithm, the computer 100 next computes the distance of all other remaining terminals of the net, e.g., the terminals 60, 62, 66, 68 in the above example, from the first terminal identified in step 36-3, e.g., the terminal 64. This procedure is described by step 36-4 in Figure 5. A second terminal which is closest to the first terminal can be identified using this information, as described by step 36-5. In the above example, the terminal 62 is the remaining terminal of the net which is closest to the first terminal 64, being three vertical channels 18A-18CC and six horizontal channels 20A-20T therefrom. The terminal 62 is therefore identified as the second terminal in this example. If more than one terminal is the same closest distance to the first terminal, any of them can be used as the second terminal.

Having identified the terminals 64, 62 as the first and second terminals, respectively, the computer 100 will next establish a first path between these terminals along vertical routing channels 18A-18CC and/or horizontal routing channels 20A-20T. This step of the router algorithm is described at 36-6 in Figure 5, with a first established path 70 illustrated in Figure 6A. The terminals 62, 64 are located on different vertical channels 18A-18CC and different horizontal channels 20A-20T. The first path 70 is therefore rectangular and has four edges 72A-72D (as described by step 36-6(a)) which are illustrated by broken lines. The first path 70 also has four vertices 74A-74D. These and subsequently discussed vertices are illustrated by circular dots in Figures 6A-6E. The vertex 74A is located at the same position on the gate array 10 as the terminal 62, while the vertex 74C is located at the same position as the terminal 64 (i.e., the four vertices of the path 70 include terminals 62, 64).

Had the first and second terminals been located on the same vertical channel 18A-18CC or the same horizontal channel 20A-20T, the first path would have been a line with one edge and two vertices including the first and second terminals. This path would then have been set as a routing channel. These steps are described at 36-6(b) and 36-7 in Figure 5. An example of a situation of this type is described subsequently.

With the first path 70 established, the computer 100 continues implementing the router algorithm by determining the shortest distance of each remaining terminal of the net to either an edge or vertex of an established path which has no edges set as a routing channel (set edges), or to a set edge of an established path which has a set edge, whichever is closest. Using this information, a remaining or next terminal which is closest to either an edge or vertex of an established path which does not have any set edges, or to a set edge or its vertices of an established path which does have a set edge, can be determined. These steps are described at 36-8 and 36-9 in Figure 5. Following the above example, the computer 100 will determine the shortest distance from each of the terminals 60, 66, 68 from one of edges 72A-72D or vertices 74A-74D of the path 70. In this example, the terminal 66 will be identified as the closest terminal to the path 70, being twelve vertical channels 18A-18CC from the edge 72B.

Having identified the next or closest remaining terminal in the manner described above, a new shortest path between the closest terminal and the edge or vertex to which it was closest is established by the computer 100, as indicated by step 36-10. In the above example, a path 76 is the shortest path between the closest terminal 66 and the edge 72B. Since the edge 72B intersects the horizontal channel 20E and the terminal 66 is positioned in the channel 20E, the path 76 is a straight line falling solely along horizontal channel 20E (i.e., no vertical channels 18A-18CC are traversed) as described by step 36-10(b) in Figure 5. As shown, the path 76 has an edge 78A and vertices 80A and 80B. The vertex 80A is located at the same position as (i.e., includes) the terminal 66, while the vertex 80B is located at the position at which the edge 78A intersects the edge 72B.

Had the shortest path between the closest remaining terminal and the edge or vertex to which it is closest required traversal of both vertical channels 18A-18CC and horizontal channels 20A-20T, the shortest path would have been rectangular and had four edges and four vertices (step 36-10(a)). The four vertices would then have included the closest terminal and a vertex in common with a vertex of the previously established path. An example of a situation of this type is described subsequently.

Following steps 36-11 and 36-12 of the router algorithm described in Figure 5, the computer 100 will set edges of the established first path 70 and/or the shortest path 76 as routing channels if certain conditions are met. Edges 72A, 72B of established path 70 which couple their vertices 74A, 74C located at the same position as terminals 62, 64, respectively, would be set as routing channels if the established path 70 and the shortest path 76 had a common vertex which is not a terminal, and the established path has no set edges (step 36-11). In the above example illustrated in Figure 6A, however, the path 70 and the path 76 do not have a vertex in common (i.e., the vertex 80B is not a vertex of the path 70) so this condition is not met. The edge of the shortest path 76 which couples the closest terminal 66 to the edge 72B of the path 70 would be set as a routing path if the path 76 is a line and has a vertex in common with a vertex of the established path 70, or if the path 76 is a line and has a vertex at a set edge of the established path 70 (step 36-12). In the above example, however, although the path 76 is a line, its vertex 80B is not common with a vertex of the established path 70, and the path 70 has no set edges. Since these conditions are not met, no edges of the path 70 or 76 will be set as routing channels by the computer 100 at this point.

The computer 100 will next determine whether the established path 70 to which the closest terminal 66 is coupled, and/or the shortest path 76 which couples the terminal 66 to the path 70, should be re-established (steps 36-13 and 36-14). The established path 70 is re-established when, as in the above example, it is a rectangle and none of its edges 72A-72D are set, and the shortest path 76 is a line and neither of its vertices 80A or 80B is common with a vertex 74A-74D of the established path 70. The shortest path 76 is re-established when, as in the above example, it is a line and neither of its vertices 80A, 80B is common with one of vertices 74A-74D of the path 70.

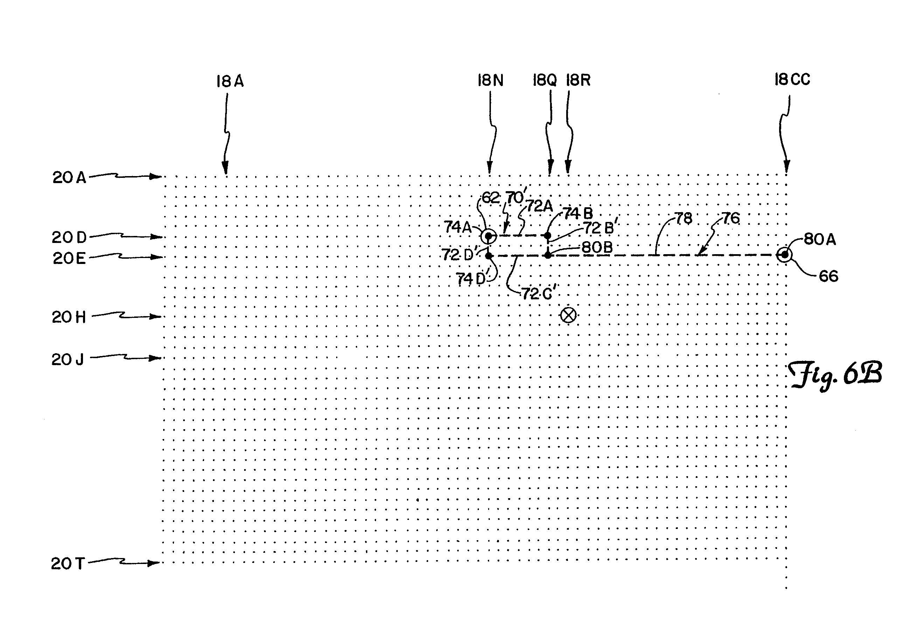

The established path 70 is re-established as a re-established path 70' and is illustrated in Figure 6B. As shown, re-established path 70' is rectangular and has four edges 72A, 72B', 72C', 72D', and four vertices 74A, 74B, 80B, 74D'. The vertices 74A, 74B are at the same location as the vertices 74A, 74B of the original established path 70. The edge 72A of the re-established path 70' is therefore the same as the edge 72A of the established path 70. The vertex 80B is common with or the same vertex as the vertex 80B of the current shortest path 76, and is therefore located at the position at which the edge 78 of the shortest path 76 intersected the edge 72B of the established path 70.

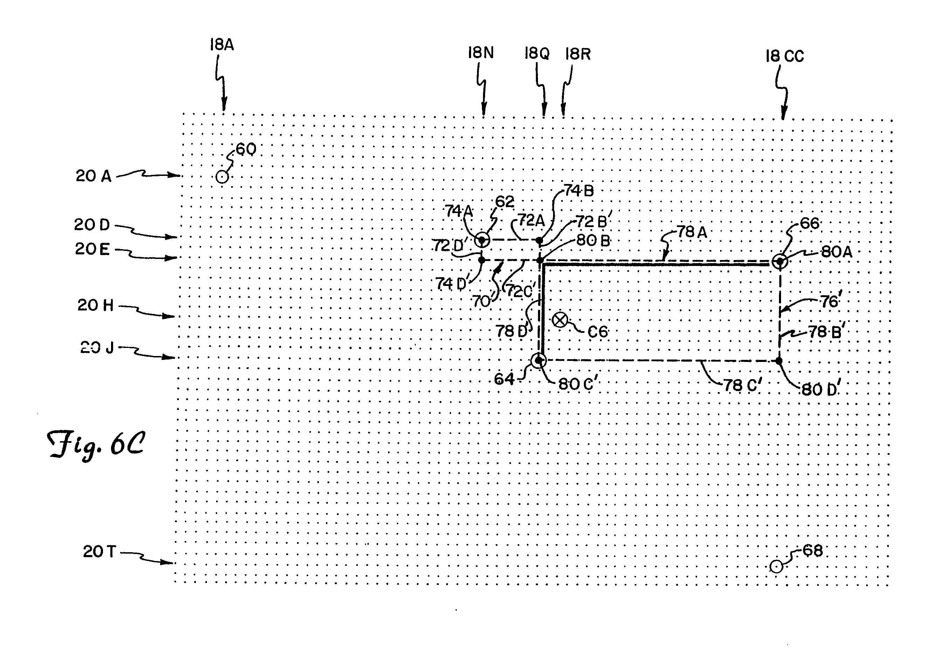

The shortest path 76 is re-established as a re-established shortest path 76' and is illustrated in Figure 6C. As shown, the re-established shortest path 76' is rectangular and includes edges 78A, 78B', 78C', 78D', and vertices 80A, 80B, 80C', 80D'. The edge 78 of the path 76' is the same edge as the edge 78 of the path 76. The vertices 80A, 80B of the path 76′ are the same vertices as the vertices 80A, 80B of the path 76. The vertex 80A is positioned at the same location as the current closest terminal 66. The vertex 80B is located at the position that the original shortest path 76 had intersected the original established path 70. The vertex 80C′ is located at a position common with the vertex 74C of the established path 70 (prior to its being re-established as the path 76′) which is also at the same position as the terminal 64.

After the computer 100 has re-established a shortest path such as the path 76, the router algorithm calls for the computer to set as routing channels edges of the re-established shortest path which couple its vertices which are also terminals and which have a vertex in common with the established path (or the re-established established path if the established path was re-established). Following the above example, the edges 78A, 78D′ of the re-established shortest path 76′ are set as routing channels as indicated by the solid lines in Figure 6C. The edges 78A, 78D′ of the path 76′ couple the current closest terminal 66 to the terminal 64 which is at the same location as the vertex 80C′ of the path 76′, while the edge 78A was also the edge 78 of the path 76. The edges 78A, 78D′ also include the vertex 80B, which is a vertex common with the re-established path 70′.

Having established a routing channel between the terminal 66 and the terminal 64, the router algorithm calls for the computer 100 to repeat the above described procedures (steps 36-8 to 36-15) for the remaining terminals of the net. At this point, all paths currently established, or those which have been re-established, are characterized as established paths for purposes of step 36-8. The terminal identified at step 36-9 is characterized as the "closest" terminal for this sequence of steps 36-8 to 36-15. The path to which the terminal identified at step 36-9 is closest is characterized as the "established" path for this repetition of steps 36-8 to 36-15.

In the example used above, the terminals 60, 68 remain. The computer 100 will then compute the shortest distance from each terminal 60, 68 to the edges 72A, 72B′-72D′ or the vertices 74A, 74B, 80B and 74D′ of the established path 70′, or to the set edges 78A, 78D′, or their vertices 80A, 80B, 80C′, of the established path 76′. The terminal 68 is fifteen horizontal channels 20A-20T from the vertex 80A of the set edge 78A of the path 76′. The terminal 60 is three horizontal channels 20A-20T and thirteen vertical channels 18A-18CC from the terminal 74A of the path 70′. The terminal 68 will therefore be identified as the current closest terminal (step 36-9).

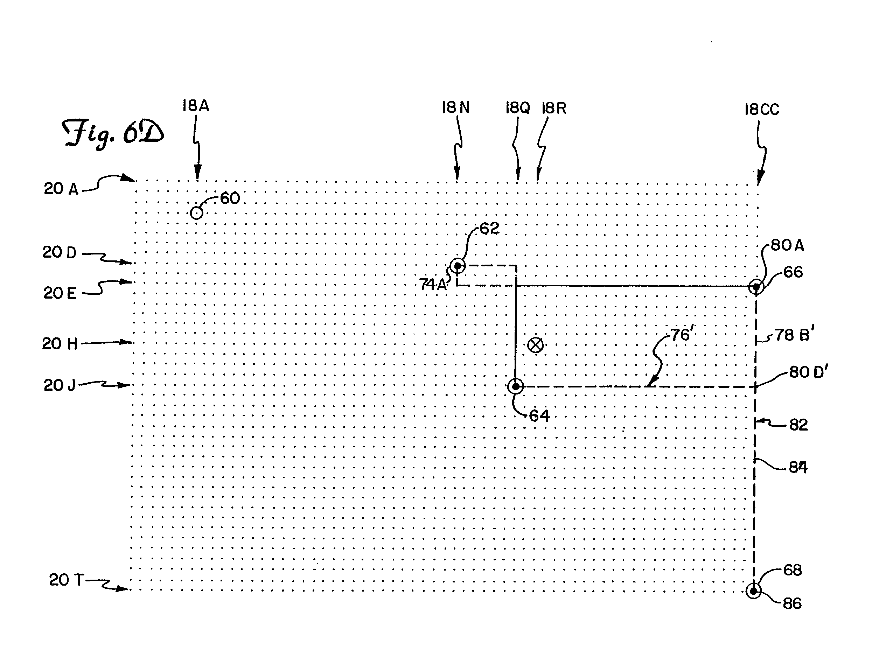

Having identified the terminal 68 as the closest terminal, a new shortest path between the terminal 68 and the vertex 80A of the path 76′ must be established along horizontal channels 20A-20T and/or vertical channels 18A-18CC (step 36-10). As shown in Figure 6D, a shortest path 82 is a line coupling the terminal 68 to the vertex 80A of the path 76′. The path 82 has an edge 84 (part of which is common with the edge 78B′ of the path 76′) and the vertices 86, 80A (step 36-10(b)). The vertex 86 is located at the same position as the terminal 68. The vertex 80A is common with the vertex 80A of the path 76′, and is located at the same position as the terminal 66.

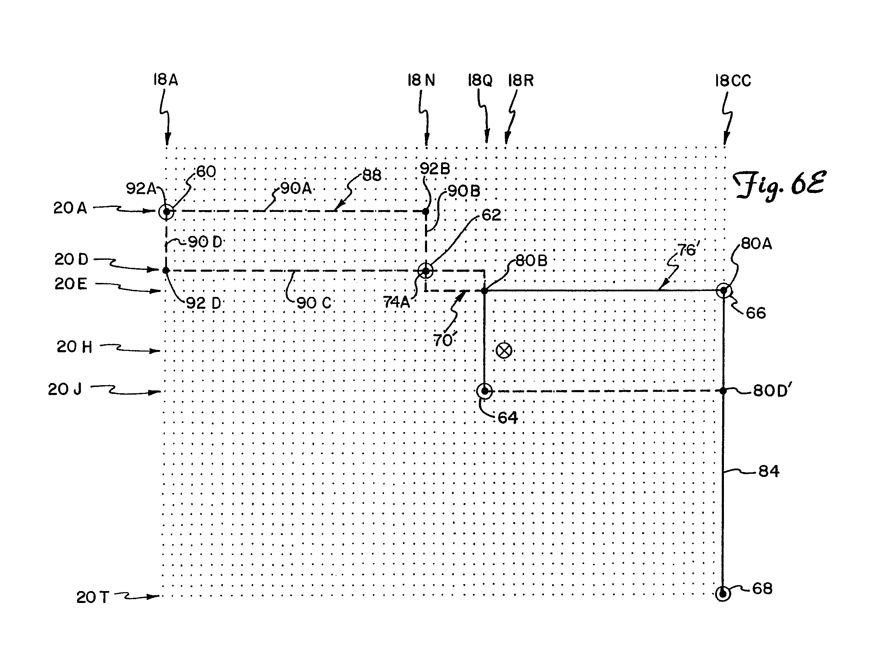

Since the current shortest path 82 is a line and has a vertex in common with a vertex of the established path 76′ (i.e., the vertex 80A), the edge 84 of the path 76′ is set as a routing channel as indicated by solid lines in Figure 6E (step 36-12). The shortest path 82 now couples the terminal 86 to a vertex of a set edge (i.e., the vertex 80A of edge 78) of the established path 76′. Since the established path 76′ already had its edges 78A, 78D′ set, it will not have additional edges set, in accordance with step 36-11. Also, since the conditions of steps 36-13 and 36-14 are not met, neither the path 76′ nor the path 82 is re-established.

Having set the edge 84 as a routing channel, the computer 100 continues implementing the router algorithm by again repeating steps 36-8 to 36-15. Since the terminal 60 is the only remaining terminal of the net, it will be identified as the closest terminal for the next sequence of steps. The terminal 60 is closest to the vertex 74A of the path 70′ which is at the same location as the terminal 62. The path 70′ is therefore the established path for this sequence of steps.

A shortest path 88 between the terminals 60.62 is established in accordance with step 36-10. As shown in Figure 6E, the shortest path 88 is a rectangle and has four edges 90A-90D, and four vertices 92A, 92B, 74A, 92D. The vertex 92A is located at the same position as the terminal 60, while the vertex 74A is a common vertex with the path 70′. In this example, the current established path 70′ does not have two vertices which are terminals (i.e., only the vertex 74A is a terminal) so following step 36-11, the computer 100 will not set edges of the path 70′ as routing channels. The current shortest path 88 is not a line, so following step 36-12, none of its edges are set as routing channels either. Similarly, since the shortest path 88 is not a line, neither the path 70′ nor the path 88 are re-established (steps 36-13 and 36-14).

After all terminals of a given net have been linked or coupled together by paths in the manner described above (e.g., terminals 62, 64, 66, 68 are coupled by the paths 70′, 76′, 82 and 88), horizontal portions or segments of the set edges of these paths (e.g., edge 78A) are assigned to specific tracks 24 within the horizontal channels 20A-20T as indicated at step 38 in Figure 3 and described above. Finally, after all nets on the gate array 10 have been global routed and maze routed in accordance with steps 36 and 38 and illustrated in Figure 3, vertical segments of the set edges are assigned to specific vertical tracks 22 within the vertical channels 18A-18CC as indicated at step 42 and described above.

It is evident from Figure 6E, however, that no edges of the paths 70' or 88 have been set. Specific routing channels by which the terminals 60, 62 are coupled to the vertex 80B, and therefore to the terminals 64, 66, 68 are not determined. In one embodiment of the present invention, the computer 100 is free to use any track 22, 24 within any vertical channel 18A-18CC and horizontal channel 20A-20T, respectively, encompassed by and including the edges of the paths 70', 88 when maze routing (step 38) and global routing (step 42). The terminal 60 can be coupled to the terminal 62, for example, using portions of any of the tracks 22 within the vertical channels 18A-18N, and the tracks 24 within the horizontal channels 20A-20D. In a similar manner, the terminal 62 can be coupled to the vertex 80B (and therefore the terminals 64, 66, 68 through set edges 76', 84), using portions of any of the tracks 22 within the vertical channels 18N-18Q and the tracks 24 within the horizontal channels 20D and 20E. Tracks 22, 24 can therefore be flexibly utilized by the computer 100 in response to routing demands or requirements from other nets.

The present invention described above has significant advantages over the prior art. Tests have shown it to be very reliable in that it can accurately assign virtually all required routing paths. Length of the interconnect paths, and therefore the amount of metal required, is kept to a minimum. As discussed above, routing paths can be flexibly utilized in response to demands from other nets to be interconnected. The method according to the present invention is also relatively fast.

## Claims

1. A method of operating a digital computer to set routing paths along an x-y grid (10) of possible paths, between a plurality of terminals (60, 62, 64, 66, 68) on an integrated circuit, characterised by including:

a) determining an average position on the grid of the terminals (60, 62, 64, 66, 68) to be interconnected;

b) identifying a first terminal (64) closest to the average position along x and/or y paths of the grid;

c) identifying a second terminal (62) closest to the first terminal (64) along x and/or y paths of the grid;

d) establishing a first path (70) along x and/or y paths of the grid between the first and second terminals (64, 62) wherein the first path (70) is rectangular and has four edges (72A-72D) and four vertices (74A-74D) including the first and second terminals (64, 62) when the first and second terminals are on different x and y paths, and wherein the first path (70) is a line and has one edge and two vertices including the first and second terminals when the first and second terminals are on the same x or y path;

e) setting the edge of the first path (70) as a routing path if the first path is a line;

f) identifying a closest remaining terminal (66) which is closest along x and/or y paths of the grid, to an edge (72B) or vertex of an established path (70) having no set edges, or to a set edge or its vertices of an established path which has a set edge, whichever is closest;

g) establishing a shortest path (76) along x and/or y paths of the grid between the closest terminal (66) and the edge (72B) or vertex of the established path to which it was closest, wherein the shortest path is rectangular and has four edges (78) and four vertices (80A, 80B) including the closest terminal (66) and a vertex common with a vertex of the established path (70) when the shortest path traverses both x and y paths of the grid, and wherein the shortest path is in line and has an edge and two vertices including the closest terminal when the shortest path traverses only x or only y paths of the grid;

h) setting as a routing path edges (72A, 72B) of the established path (70) which couple its vertices (74A, 74C) which include terminals (62, 64) and which have a vertex in common with the shortest path, if the established path has no set edges and the common vertex does not include a terminal;

i) setting as a routing path the edge of the shortest path (76) which couples the closest terminal to the edge (72B) or vertex of the established path (70) if the shortest path is a line and has a vertex common with a vertex of the established path, or is a line and has a vertex at a set edge of the established path; and

j) repeating steps f) to i) for remaining terminals to be interconnected.

2. A method as claimed in claim 1 characterised by including, between steps i) and j):

k) re-establishing the established path to which the closest terminal (66) was closest if the established path (70) is a rectangle with no set edges (72A-72D) and the shortest path (76) is a line which does not have a vertex common with a vertex of the established path, wherein the re-established established path (70') is rectangular and has four edges (72A, 72B'-72D') and four vertices (74A, 74B, 80B, 74D') including two vertices (74A, 74B) of the established path and a vertex (80B) common with the vertex of the shortest path (76) which intersected the established path;

l) re-establishing the shortest path (76) if the shortest path is a line and does not have a vertex common with a vertex of the established path to which the closest terminal was closest (prior to being re-established if it was re-established), wherein the re-established shortest path (76') is a rectangle and has four edges (78A, 78B'-78D') and four vertices (80A, 80B 80C', 80D') including a vertex including the closest terminal, a vertex (80B) at the intersection of the shortest path (76) and the established path (70) or the re-established established path (70'), and a vertex (80C') common with a vertex (74C) of the established path (70) (prior to being re-established if it was re-established) which includes a terminal; and

m) setting as a routing path edges (78A, 78D') of the re-established shortest path (76') which couple its vertices which include terminals (64) and which have a vertex common with a vertex of the established path (70) or the re-established established path (70').

3. A method of operating a digital computer to set routing paths, along an x-y grid (10) of possible paths, between a plurality of terminals (60, 62, 64, 66, 68) on an integrated circuit, characterised by including:

a) determining an average position on the grid of the terminals (60, 62, 64, 66, 68) to be interconnected;

b) identifying a first terminal (64) closest to the average position along x and/or y paths of the grid;

c) identifying a second terminal (62) closest to the first terminal (64) along x and/or y paths of the grid;

d) establishing a first path (70) along x and/or y paths of the grid between the first and second terminals (64, 62) wherein the first path (70) is rectangular and has four edges (72A-72D) and four vertices (74A-74D) including the first and second terminals (64, 62) when the first and second terminals are on different x and different y paths, and wherein the first path (70) is a line and has one edge and two vertices including the first and second terminals when the first and second terminals are on the same x or same y path;

e) setting the edge of the first path (70) as a routing path if the first path is a line;

f) identifying a closest remaining terminal which is closest, along x and/or y paths of the grid, to an edge (72B) or vertex of an established path (70) having no set edges, or to a set edge or its vertices of an established path which has a set edge, whichever is closest;

g) establishing a shortest path (76) along x and/or y paths between the closest terminal (66) and the edge (72B) or vertex of the established path to which it was closest, wherein the shortest path is rectangular and has four edges (78) and four vertices (80A, 80B) including the closest terminal (66) and a vertex common with a vertex of the established path (70) when the shortest path traverses both x and y paths, and wherein the shortest path is a line and has an edge and two vertices including the closest terminal when the shortest path traverses only x or only y paths;

h) setting as a routing path edges (72A, 72B) of the established path (70) which couple its vertices (74A, 74C) which are also terminals (62, 64) and which have a vertex common with a vertex of the shortest path, if the established path has no set edges and the common vertex does not include a terminal;

i) setting as a routing path the edge of the shortest path (76) which couples the closest terminal to the edge (72B) or vertex of the established path (70) if the shortest path is a line and has a vertex common with a vertex of the established path, or is a line and has a vertex at a set edge of the established path;

j) re-establishing the established path to which the closest terminal (66) was closest if the established path (70) is a rectangle with no set edges (72A-72D) and the shortest path (76) is a line which does not have a vertex common with a vertex of the established path, wherein the re-established established path (70') is rectangular and has four edges (72A, 72B'-72D') and four vertices (74A, 74B, 80B, 74D') including two vertices (74A, 74B) of the established path and a vertex (80B) common with the vertex of the shortest path (76) which intersected the established path;

k) re-establishing the shortest path (76) if the shortest path is a line and does not have a vertex common with a vertex of the established path to which the closest terminal was closest (prior to being re-established if it was re-established), wherein the re-established shortest path (76') is a rectangle and has four edges (78A, 78B'-78D') and four vertices (80A, 80B, 80C', 80D') including a vertex at the location of the closest terminal, a vertex (80B) at the location at which the shortest path (76) intersected the established path (70) or the re-established established path (70'), and a vertex (80C') common with a vertex (74C) of the established path (70) (prior to being re-established if it was re-established), which includes a terminal;

l) setting as a routing path edges (78A, 78D') of the re-established shortest path (76') which couple its vertices which include terminals (64) and which have a vertex common with a vertex of the established path (70) or the re-established established path (70'); and

m) repeating steps f) to l) for remaining terminals to be interconnected.

4. A method as claimed in any preceding claim characterised by setting as a routing path any of the possible paths within and including edges of the established paths which have no set edges and which couple the terminals of the established paths to a set edge or its vertices of an established path having a set edge.

Fig.1

EP 0 296 697 A2

100

RAM —106

I/O UNIT ⇄ CPU ⇄

MASS STORAGE —108

—102 —104

*Fig. 2*

LAY OUT LOGIC MACROS AND MACRO INTRACONNECT METAL —32

GET NET LIST —34

GLOBAL ROUTE NET INTERCONNECTS TO VERTICAL AND HORIZONTAL CHANNELS —36

MAZE ROUTE HORIZONTAL SEGMENTS TO TRACKS OF GLOBAL ROUTE CHANNELS —38

YES ◇ MORE NETS? —40

NO

CHANNEL ROUTE VERTICAL SEGMENTS TO TRACKS OF GLOBAL ROUTE CHANNELS —42

*Fig. 3*

Fig. 4

18A  18B      18G          18N      18Q              18AA  18CC

50

20 A

60

62    52                          56
20 D
20E                    ID                    66
                                                      I

                       CI

                           54
64
20 J                       ID

                           CI

10

58
68
20 T                                                  I

EP 0 296 697 A2

# *Fig.5*

36-1    Determine the center of gravity of the terminals of the net.

36-2    Determine the distance, in terms of the vertical and/or horizontal channels, of each terminal of the net from the center of gravity.

36-3    Identify a first terminal closest to the center of gravity.

36-4    Determine the distance in terms of vertical and horizontal channels, of remaining terminals of the net from the first terminal.

36-5    Identify a second terminal closest to the first terminal.

36-6    Establish a first path between the first and second terminals along vertical and/or horizontal channels

   36-6(a) The first path will be rectangular and have four edges and four vertices including the first and second terminals when the first and second terminals are at different vertical and different horizontal channels.

   36-6(b) The first path will be a line and have one edge and two vertices including the first and second terminals when the first and second terminals are at the same vertical or same horizontal channels.

36-7    Set the edge of the first path as a routing channel if the first path is a line.

36-8    Determine the distance, in terms of vertical and/or horizontal channels, of remaining terminals of the net from either an edge or vertex of an established path having no set edges or from a set edge or its vertices of an established path which has one or more set edges, whichever is closest.

36-9    Identify a closest terminal closest to an edge or vertex of an established path having no set edges or from a set edge or its vertices of an established path which has one or more set edges, whichever is closest.

36-10   Establish a shortest path between the closest terminal identified immediately above in step 36-9 and the edge or vertex of the established path to which it was closest.

   36-10(a)  The shortest path will be rectangular and have four edges and four vertices including the closest terminal and a vertex in common with a vertex of the established path when the shortest path requires both vertical and horizontal channels.

   36-10(b)  The shortest path will be a line and have one edge and two vertices including the closest terminal when the shortest path requires only vertical or horizontal channels.

36-11  Set as routing channels edges of the established path which couple its vertices which are also terminals and which have a vertex in common with the shortest path if the common vertex is not positioned at the same location as a terminal and the established path has no set edges.

36-12  Set as routing channels the edge of the shortest path which couples the closest terminal to the edge or vertex of the established path if the shortest path is a line and has a vertex in common with a vertex of the established path, or is a line and has a vertex at a set edge of the established path.

36-13  Reestablish the established path if the established path is a rectangle with no set edges and the shortest path is a line which does not have a vertex in common with a vertex of the established path.  The reestablished path will be rectangular and have four edges and four vertices including two vertices of the established path and a vertex common with the vertex of the shortest path which intersected the established path.

36-14  Reestablish the shortest path if the shortest path is a line and does not have a vertex common with a vertex of the established path.  The reestablished shortest path will be a rectangle and have four edges and four vertices including a vertex at the location of the closest terminal, a vertex at the location at which the shortest path intersected the established path (or the reestablished established path) and a vertex common with a vertex of the established path (prior to it being reestablished if it was reestablished) which is also a terminal.

36-15  Set as routing channels edges of the reestablished shortest path which couple its vertices which are also terminals and which have a vertex in common with the established path (or the reestablished established path).

36-16  Repeat steps 36-8 through 36-15 for all remaining terminals of the net.

*Fig.5*

Fig. 6A

18A      18N   18Q   18R      18CC

20A   60
20D
20E
20H
20J
20T   68

74A   62   72A   74B   70
78A   80A
76
80B
66
72B
72D
72C
CG
74D   74C
64

EP 0 296 697 A2

Fig. 6B

Fig. 6C

Fig. 6D

Fig. 6E